# EUROPEAN PATENT APPLICATION

(11) **EP 1 814 218 A1**
(43) Date of publication of application: **01.08.2007**
(21) Application number: 06027093.1
(22) Date of filing: 29.12.2006
(51) Int. Cl.: H03B 29/00

(54) **Frequency synthesizer**

(30) Priority: 05.01.2006 JP 2006000541; 02.10.2006 JP 2006270825
(71) Applicant: Yokogawa Electric Corporation, Tokyo 180-8750 (JP)
(72) Inventor: Yoshitake, Satoshi, Musashino-shi Tokyo 180-8750 (JP); Tanaka, Ryuta, Musashino-shi Tokyo 180-8750 (JP)
(74) Representative: Grünecker, Kinkeldey, Stockmair & Schwanhäusser Anwaltssozietät

(57) **Abstract**

A frequency synthesizer includes: a signal generation section for outputting a signal having a desired frequency; a noise generation section for generating a noise to be a set value; and a noise adding section for adding the noise from the noise generation section to the signal from the signal generation section.

## Description

This application claims foreign priorities based on Japanese Patent application No. 2006-000541, filed January 5, 2006, and Japanese Patent application No. 2006-270825, filed October 2, 2006, the contents of which are incorporated herein by reference in their entireties.

### BACKGROUND OF THE INVENTION

### 1. Field of the Invention

The present invention relates to a frequency synthesizer having a signal generation section for outputting a signal having a desired frequency, and in particular, relates to a frequency synthesizer for outputting a frequency signal to which a desired noise is added.

### 2. Description of the Related Art

A frequency synthesizer is a device which synthesizes frequencies to generate and output a desired frequency having high accuracy and high spectral purity with less phase noises, etc. The frequency synthesizer is used for a carrier signal in radio communications, a mixer for transmitter/receiver in a communications system, a signal used for a test of an electric circuit, etc.

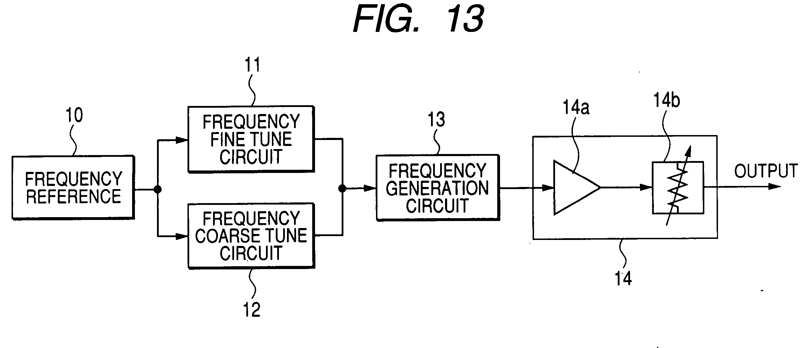

Fig. 13 is a constitutional diagram showing an example of a frequency synthesizer of a related art (for example, see JP-A-11-8554, JP-A-11-225022 and JP-A-2003-283334).

In Fig. 13, a frequency reference 10 outputs a frequency reference signal. A frequency fine tune circuit 11 receives the signal from the frequency reference 10. A frequency coarse tune circuit 12 receives the signal from the frequency reference 10. A frequency generation circuit 13 receives signals from the frequency fine tune circuit 11 and the frequency coarse tune circuit 12. An amplitude regulation section 14 has an amplifier 14a and an attenuator 14b, the amplifier 14a receives a signal from the frequency generation circuit 13, and the attenuator 14b receives a signal from the amplifier 14a. Incidentally, at least one of the frequency reference 10, the frequency fine tune circuit 11 and the frequency generation circuit 13 is constituted by a closed loop and has a predetermined loop band. Further, a signal generation section includes the frequency reference 10, the frequency fine tune circuit 11, the frequency coarse tune circuit 12, the frequency generation circuit 13, and the amplitude regulation unit 14.

An operation of the device as described above will be explained.

The frequency reference 10 outputs the frequency reference signal having high frequency stability, high accuracy, and remarkably high spectral purity having low phase noises (low jitter). Incidentally, the frequency reference 10 outputs a plurality of frequency reference signals, each of which is different frequency (for example, 100 [MHz], 200 [MHz], 400 [MHz], etc.) but these frequencies are fixed. The frequency reference 10 described above regards OCXO (Oven Control Xtal Oscillator), for example, as a reference frequency, and includes a multiply circuit, a divider circuit, a PLL (Phase Locked Loop) circuit, etc.

The frequency fine tune circuit 11 then outputs an output signal in which a frequency of a fine frequency step (for example, 1 [Hz] step) is regulated on the basis of the frequency reference signal from the frequency reference 10. As such the frequency fine tune circuit 11, for example, a PLL circuit of Fractional-N type, a DDS (Direct Digital Synthesizer), etc., is used.

On the contrary, the frequency coarse tune circuit 12 converts the respective frequency based on the frequency reference signal from the frequency reference 10 into a desired frequency signal. Incidentally, the band that can be frequency-converted by the frequency coarse tune circuit 12 is wider than the frequency band of the frequency reference signal output from the frequency reference 10.

The frequency generation circuit 13 then outputs a desired frequency signal in which the frequency is regulated with a wide band, in accordance with the fine-adjusted signal by the frequency fine tune circuit 11 and the frequency converted signal by the frequency coarse tune circuit 12. The frequency generation circuit 13 is composed of, for example, a PLL circuit using VCO (Voltage Controlled Oscillator) or YTO (YIG Tuned Oscillator) having a wide band as a main oscillator. Incidentally, YIG means Yttrium-Iron-Garnet (Y₃Fe₅O₁₂).

Moreover, the amplifier 14a in the amplitude regulation section 14 amplifies the signal from the frequency generation circuit 13, and the attenuator 14b attenuates the signal from the amplifier to adjust the signal level into a desired output level (amplitude) and outputs the signal.

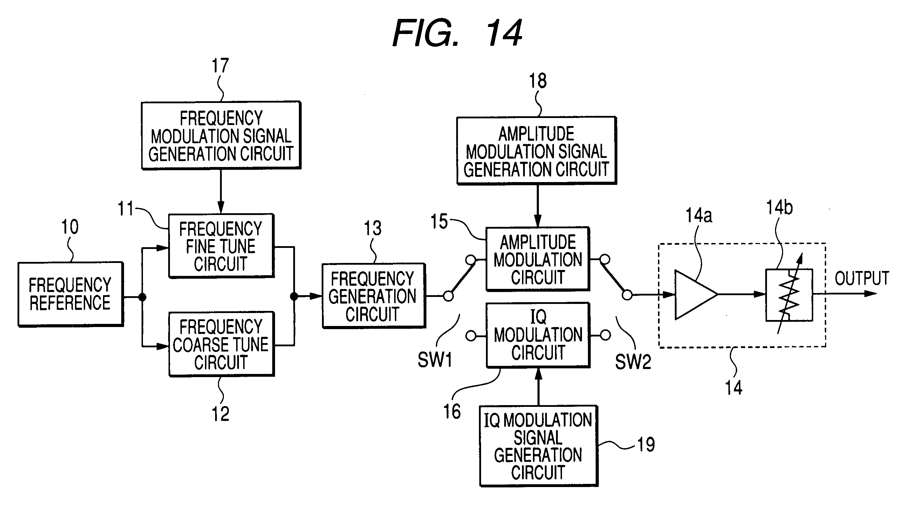

Next, Fig. 14 is a diagram showing another constitution of a frequency synthesizer of a related art describing one example for outputting a modulated signal. Here, the same reference numerals are appended to the same elements as indicated in Fig. 13, and the explanation to the same elements are omitted. An amplitude modulation circuit 15 and an IQ modulation circuit 16 are provided between the frequency generation circuit 13 and amplitude regulation unit 14 in parallel. In addition, a frequency modulation signal generation circuit 17, an amplitude modulation signal generation circuit 18 and an IQ modulation signal generation circuit 19 are newly provided. The frequency modulation signal generation circuit 17 then outputs a modulation signal for performing the frequency modulation to the frequency fine tune circuit 11. The amplitude modulation signal generation circuit 18 outputs a modulation signal for performing the amplitude modulation to the amplitude modulation circuit 15. The IQ modulation signal generation outputs a modulation signal for performing the IQ modulation to the IQ modulation circuit 16.

A switch SW1 connects the output side of frequency generation circuit 13 to the input side of either the amplitude modulation circuit 15 or IQ modulation circuit 16. A switch SW2 connects the input side of amplitude regulation section 14 to the output side of either the amplitude modulation circuit 15 or IQ modulation circuit 16.

An operation of the device as described above will be explained. The sections different from Fig. 13 are mainly described.

First, an operation is explained in a case of the frequency modulation.

The frequency modulation signal generation circuit 17 generates a modulation signal used for a desired frequency modulation, digitizes the generated modulation signal, and outputs the digitized modulation signal to the frequency fine tune circuit 11. A DDS, etc., in the frequency fine tune circuit 11 then outputs a frequency modulated signal on the basis of the modulation signal. The frequency modulation signal generation circuit 17 as described above includes the DDS, etc., for example.

Further, similarly to the device shown in Fig. 13, the frequency generation circuit 13 outputs a desired frequency signal in accordance with the signals output from the frequency fine tune circuit 11 and frequency coarse tune circuit 12. However, the signal output from the frequency generation circuit 13 is frequency-modulated because the signal from the frequency fine tune circuit 11 is also frequency-modulated.

The frequency generation circuit 13 then outputs the desired frequency signal in which the frequency is regulated at wide band, in accordance with the signal finely regulated with by the frequency fine tune circuit 11 and the signal that is frequency-modulated by the frequency coarse tune circuit 12. Of course, a control band (loop band) of a PLL circuit (not shown) in the frequency generation circuit 13 including a main oscillator (not shown) is wider than the frequency modulated band.

Subsequently, an operation will be explained in a case of the amplitude modulation.

The amplitude modulation signal generation circuit 18 generates a modulation signal used for a desired amplitude modulation, and outputs the generated modulation signal to the amplitude modulation circuit 15. The amplitude modulation circuit 15 then performs the amplitude modulation on the signal from the frequency generation circuit 13 on the basis of the modulation signal, and outputs the signal to the amplitude regulation section 14. The amplitude modulation signal generation circuit 18 as described above includes the DDS, etc., for example. The amplitude modulation circuit 15 includes a variable attenuator, for example.

Subsequently, an operation will be explained in a case of the IQ modulation.

The IQ modulation signal generating circuit 19 generates a quadrature modulation signal used for the IQ modulation to be a desired I (In-Phase) and Q (Quadrature-Phase), and outputs the signal to the IQ modulation circuit 16. The IQ modulation circuit then performs the IQ modulation on the signal from the frequency generation circuit 13 on the basis of the quadrature modulation signal, and outputs to the amplitude regulation section 14. The IQ modulation signal generating circuit 19 as described above includes the DDS, etc., for example.

Incidentally, in a case of performing the amplitude modulation on the signal from the frequency generation circuit 13, the switches SW1 and SW2 switch the connections to the side of amplitude modulation circuit 15. On the contrary, in a case of performing the IQ modulation on the signal from the frequency generation circuit 13, the switches SW1 and SW2 switch the connections to the side of IQ modulation circuit 16. Other operation is the same as the device shown in Fig. 13, therefore, an explanation thereof is omitted.

The device as described above shown in Fig. 13 can generate a remarkably low noise signal because the frequency reference signal having high spectral purity is regarded as a reference, so that the frequency setting can be carried out in high resolution by the frequency fine tune circuit 11. The device shown in Fig. 14 can perform various types of modulation (amplitude modulation, frequency modulation, IQ modulation, pulse modulation, etc.) on the high spectral purity signal in high accuracy.

On the contrary, in the case of evaluations, tests, etc., of devices incorporated in the radio communications equipment, it is necessary to carry out a margin test for noises (particularly, phase noise, so-called jitter) to be mixed on a carrier signal. As one example in this case, there have arisen many demands such that the evaluations, tests, etc., for the noise resistance properties of the radio communications equipment, devices, etc., as objects to be tested should be carried out in such away that the spectral purity of carrier signal is quantitatively deteriorated. In a case of the aforementioned evaluations, tests, etc., there have been many cases that the output signal from the frequency synthesizer shown in Fig. 13 and Fig. 14 is used as a carrier signal.

However, a major purpose of the frequency synthesizer of the related art is to set the frequency in high resolution, output a low noise signal, and perform various types of modulation in high accuracy.

For this reason, in a case of adding the phase noise, in the related art, a user adds white noises to the signals from the modulation signal generation circuits 17, 18 and 19 to make a spectral line width thick, so that the phase noise is added to the extent of appearance. Therefore, there has been a problem that it is difficult to output a carrier signal having a desired spectral purity to objects to be tested and to measure the noise resistance properties of the objects to be tested in high accuracy.

### SUMMARY OF THE INVENTION

The present invention has been made in view of the above circumstances, and provides a frequency synthesizer for outputting a frequency signal to which a desired noise is added.

In some implementations, a frequency synthesizer of the invention, comprising:
a signal generation section for outputting a signal having a desired frequency;
a noise generation section for generating a noise to be a set value; and
a noise adding section for adding the noise from the noise generation section to the signal from the signal generation section.

In the frequency synthesizer, the noise generation section generates the noise that makes a spectrum of the signal from the signal generation section be a desired shape, on the basis of a loop band of the signal generation section.

In the frequency synthesizer, the noise generation section generates at least one of a phase noise, an amplitude noise, and a noise floor.

In the frequency synthesizer, the noise generation section includes:
a white noise generation section for outputting a white noise;
a phase noise characteristic regulation section for obtaining a phase modulation amount on the basis of a loop band of the signal generation section;
a frequency regulation section for regulating a frequency characteristic of the white noise from the white noise generation section in accordance with an instruction from the phase noise characteristic regulation section; and
an amplitude regulation section for regulating an amplitude characteristic of a signal from the frequency regulation section in accordance with an instruction from the phase noise characteristic regulation section.

In the frequency synthesizer, the noise adding section is a quadrature modulator.

The frequency synthesizer, further comprising:
a phase difference generation section for dividing the signal from the signal generation section into signals having a phase difference of 90°;
multipliers for performing an amplitude modulation corresponding to a signal from the noise generation section, on each of the signals divided by the phase difference generation section; and
an adder for adding outputs from the multiplier.

In the frequency synthesizer, the noise generation section includes:
a white noise generation section for outputting a white noise; an amplitude noise characteristic regulation section for obtaining an amplitude modulation amount on the basis of a loop band of the signal generation section;
a frequency regulation section for regulating a frequency characteristic of the white noise from the white noise generation section in accordance with an instruction from the amplitude noise characteristic regulation section; and
an amplitude regulation section for regulating an amplitude characteristic of a signal from the frequency regulation section in accordance with an instruction from the amplitude noise characteristic regulation section.

In the frequency synthesizer, the noise adding section includes a variable attenuator for performing an amplitude modulation corresponding to a signal from the noise generation section, on the signal from the signal generation section.

In the frequency synthesizer, the noise adding section includes a variable attenuator for attenuating the signal from the signal generation section, and
the noise generation section includes:
a level detector for obtaining a ratio of a electric power level and a noise level of a center frequency of the signal from the signal generation section; and
a noise floor characteristic regulation section for regulating an attenuation amount of the variable attenuator on the basis of the ratio obtained by the level detector. The frequency synthesizer, further comprising:
   a phase noise measurement section for measuring a phase noise of the signal to which the phase noise is added by the noise adding section; and
   a subtractor for outputting a signal that reduces an error between the set value and the phase noise measured by the phase noise measurement section, to the noise generation section.

The frequency synthesizer, further comprising:
an electric power detection section for detecting an electric power of the signal to which an amplitude noise is added by the variable attenuator and outputting a voltage value corresponding to a magnitude of the detected electric power;
a reference voltage output section for outputting a reference voltage;
an adder for adding the amplitude noise from the noise generation section, to the reference voltage from the reference voltage output section; and
a subtractor for outputting a signal that reduces an error between the reference voltage from the adder and the voltage value as a detection result by the electric power detection section, to the variable attenuator.

### BRIEF DESCRIPTION OF THE DRAWINGS

Fig. 1 is a constitutional diagram showing a first embodiment of the present invention.
Fig. 2 is a diagram showing one example of adding the phase noise to the carrier signal.
Fig. 3 is a diagram showing a detailed constitution of the phase noise generation section 21 and the phase noise adding section 26 shown in Fig. 1.
Fig. 4 is a constitutional diagram showing a second embodiment of the invention.
Fig. 5 is a diagram showing one example of adding the amplitude noise to the carrier signal.
Fig. 6 is a diagram showing a detailed constitution of the amplitude noise generation section 31 and the amplitude noise adding section 36 shown in Fig. 4.
Fig. 7 is a constitutional diagram showing a third embodiment of the invention.
Figs. 8A-SD are diagrams representing the spectrums of a signal in the device shown in Fig. 7.
Fig. 9 is a constitutional diagram showing a fourth embodiment of the invention.
Fig. 10 is a constitutional diagram showing a fifth embodiment of the invention.
Fig. 11 is a constitutional diagram showing a sixth embodiment of the invention.
Fig. 12 is a constitutional diagram showing a seventh embodiment of the invention.
Fig. 13 is a diagram showing the constitution of a frequency synthesizer of a related art.
Fig. 14 is a diagram showing another constitution of a frequency synthesizer of a related art.

### DESCRIPTION OF THE PREFERRED EMBODIMENTS

Hereinafter, embodiments of the invention will be explained with reference to the drawings.

### [First embodiment]

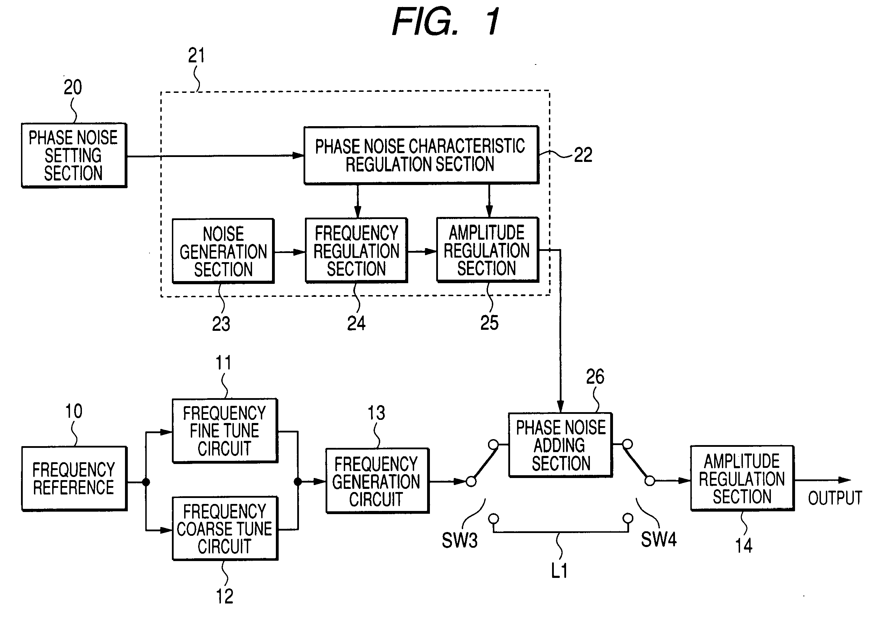

Fig. 1 is a constitutional diagram showing a first embodiment of the invention. Here, the same reference numerals are appended to the same elements as indicated in Fig. 13, and the explanation thereof is omitted. Incidentally, as one example of the explanation, the explanation will be made as to an example in which a signal output from the device of the invention is used as a carrier signal, for carrying out evaluations, tests, etc., of radio communications equipment, devices, etc. Of course, the signal output from the device may also be used for a signal, etc., to carry out a test for mixers of a transmitter/receiver unit and electric circuits in a communications system.

Fig. 1 shows a case where desired phase noises are added to a carrier signal output by a frequency synthesizer. Specifically, the phase modulation is performed, and the noises are added to the carrier signal. In Fig. 1, a phase noise setting section 20 is newly provided and sets set values of the phase noises to be contained in the signal output by the amplitude regulation section 14.

A phase noise generation section 21 is newly provided, and has a phase noise characteristic regulation section 22, a noise generation section 23, a frequency regulation section 24, and an amplitude regulation section 25, and receives the set values from the phase noise setting section 20.

The phase noise characteristic regulation section 22 receives the set values from the phase noise setting section 20. A noise generation section 23 outputs white noises. The frequency regulation section 24 filters the white noises from the noise generation section 23, and regulates their frequency characteristics in accordance with an instruction from the phase noise characteristic regulation section 22. The amplitude regulation section 25 regulates an amplitude characteristic of every frequency component which is filtered by the frequency regulation section 24.

A phase noise adding section 26 is provided between the frequency generation circuit 13 and amplitude regulation section 14, and performs the phase modulation on the signal from the frequency generation circuit 13 on the basis of a signal from the amplitude regulation section 25. Incidentally, the phase noise generation section 21 corresponds to a noise generation section, and the phase noise adding section 26 corresponds to a noise adding section.

A transmission path L1 is provided between the frequency generation circuit 13 and the amplitude regulation section 14 in parallel with the phase noise adding section 26. A switch SW3 connects the output side of frequency generation circuit 13 to the input side of either the phase noise adding section 26 or a transmission path L1. A switch SW4 connects the input side of amplitude regulation section 14 to the output side of either the phase noise adding section 26 or the transmission path L1.

An operation of the device described above will be explained. Set values (for example, -20 [dBc/Hz] at Δf1 (an offset frequency from the carrier frequency), -50 [dBc/Hz] at Δf2, and -80 [dBc/Hz] at Δf3) for the phase noises are set in the phase noise setting section 20. The set values which have been set are then output to the phase noise characteristic regulation section 22.

Further, the phase noise characteristic regulation section 22 obtains a phase modulation amount to be the set values from the phase noise setting section 20, namely, frequencies for the phase modulation and amplitudes of the respective frequencies, on the basis of an output frequency of the frequency reference 10, an output frequency of the frequency fine tune circuit 11, a loop bandwidth of the frequency generation circuit 13, and a modulation band of the phase noise adding section 26. The phase noise characteristic regulation section 22 then outputs an instruction to the frequency regulation section 24 to filter the obtained frequencies, and outputs an instruction to the amplitude regulation section 25 to make the amplitudes to be the obtained amplitudes. Incidentally, the output frequency of the frequency reference 10, the output frequency of the frequency fine tune circuit 11, the loop band width of the frequency generation circuit 13, and the modulation band of the phase noise adding section 26, are determined in advance at a time of manufacturing the device, its calibration, etc. These may be maintained in the phase noise characteristic regulation section 22, in advance.

The frequency regulation section 24 then outputs, to the amplitude regulation section 25, only desired frequency noises among the white noises from the noise generation section 23 in accordance with the instruction from the phase noise characteristic regulation section 22. Further, the amplitude regulation section 25 regulates the amplitudes of respective frequency components from the frequency regulation section 24 in accordance with the instruction from the phase noise characteristic regulation section 22 and outputs to the phase noise adding section 26.

The phase noise adding section 26 then performs the phase modulation on the carrier signal output from the frequency generation circuit 13 and adds the phase noises to the carrier signal in accordance with the signal from the amplitude regulation section 25, and outputs to the amplitude regulation section 14.

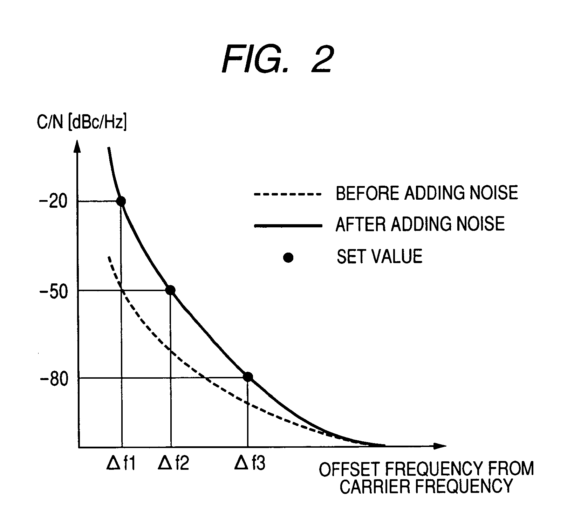

Here, Fig. 2 is a diagram showing one example of adding the phase noises to the carrier signal, in which the solid line is a spectrum after adding the phase noises to the carrier signal. The dotted line is a spectrum before adding the phase noises. The abscissa axis is frequency, and the vertical axis is C/N (Carrier to Noise) ratio (magnitude of the phase noise).

Incidentally, when the phase noises are added to the signal from the frequency generation circuit 13, the switches SW3, SW4 switch the connection to the side of phase noise adding section 26. On the other hand, when the phase noises are not added to the signal from the frequency generation circuit 13, the switches SW3, SW4 switch the connection to the side of transmission path L1.

Other operation is the same as that of the device shown in Fig. 13, therefore, the explanation thereof is omitted.

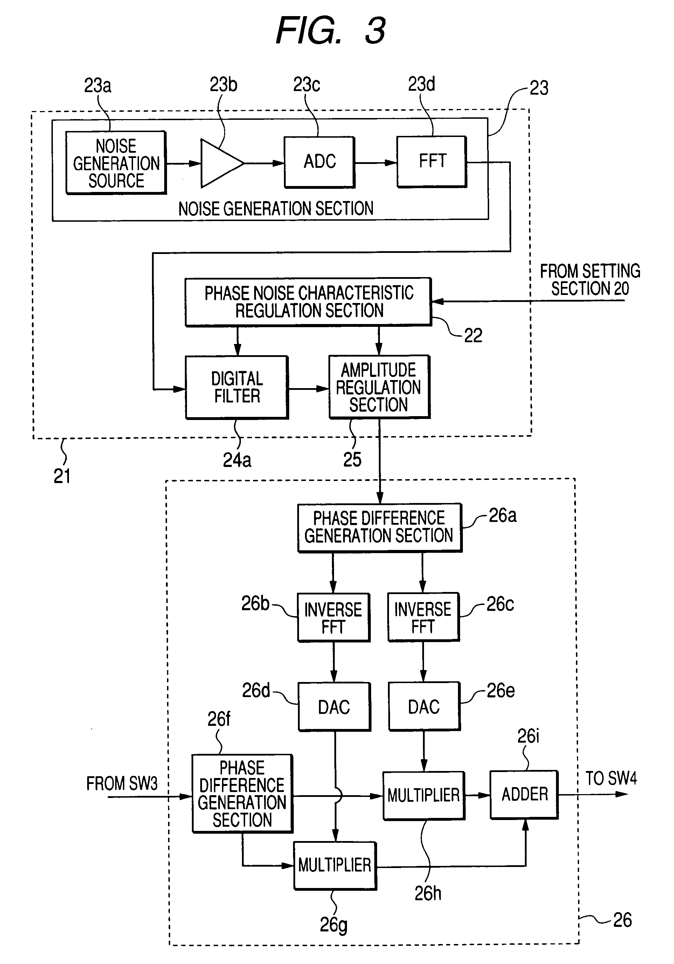

Subsequently, Fig. 3 is a diagram showing a detailed constitution of the phase noise generation section 21 and phase noise adding section 26 shown in Fig. 1. In Fig. 3, the noise generation section 23 has a noise generation source 23a, an amplifier 23b, an analog/digital converter (hereinafter, abbreviated as ADC) 23c, and an FFT operation section 23d.

The amplifier 23b receives the noise signal from the noise generation source 23a. The ADC 23c receives the noise signal amplified by the amplifier 23b. The FFT operation section 23d receives a digital signal converted by the ADC 23c. A digital filter 24a is one example of the frequency regulation section 24, and receives the instruction from the phase noise characteristic regulation section 22 and a result of the Fourier transform performed by the FFT operation section 23d.

Further, the phase noise adding section 26 is a so-called quadrature modulator, and has phase difference generation sections 26a, 26f, inverse FFT operation sections 26b, 26c, digital/analog converters (hereinafter, abbreviated as DAC) 26d, 26e, analog multipliers 26g, 26h, and an analog adder 26i.

The phase difference generation section 26a receives the signal from the amplitude regulation section 25. The inverse FFT operation section 26b receives one of signals from the phase difference generation section 26a. The inverse FFT operation section 26c receives the other of the signals from the phase difference generation section 26a. The DAC 26d receives a result of the inverse Fourier transform in the inverse FFT operation section 26b. The DAC 26e receives a result of the inverse Fourier transform in the inverse FFT operation section 26c. The phase difference generation section 26f receives the signal from the frequency generation circuit 13 through the switch SW3. The analog multiplier 26g receives one of signals from the phase difference generation section 26f and an analog signal converted in the DAC 26d. The analog multiplier 26h receives the other of the signals from the phase difference generation section 26f and an analog signal converted in the DAC 26e. The adder 26i adds a multiplied result in the multipliers 26g, 26h and outputs to the switch SW4.

An operation of the device as described above will be explained.

The amplifier 23b amplifies the white noises output from the noise generation source 23a by a predetermined gain and outputs to the ADC 23c. The ADC 23c then converts the white noises of an analog signal into a digital signal and outputs to the FFT operation section 23d. Further, the FFT operation section 23d performs the Fourier transform with a digital signal and outputs to the digital filter 24a.

The digital filter 24a then filters the Fourier transformed data (of course, spectrums are present uniformly at a predetermined band) in accordance with the instruction from the phase noise characteristic regulation section 22, and transmits only spectrums present in desired frequencies. Further, the amplitude regulation section 25 regulates electric powers of the spectrums for each of the frequencies after filtered by the digital filter 24a, and outputs to the phase difference generation section 26a.

The phase difference generation section 26a then generates two signals having the phase difference of 90° therebetween from the output signal of the amplitude regulation section 25, and outputs one of the two signals to the inverse FFT operation section 26b and the other thereof to the inverse FFT operation section 26c. The respective inverse FFT operation sections 26b, 26c perform respectively the inverse the Fourier transform, and output transformed results to the DACs 26d, 26e, respectively. Further, the respective DACs 26d, 26e convert the digital signals to analog signals and output to the multipliers 26g, 26h, respectively.

On the contrary, the phase difference generation section 26f divides the signal from the frequency generation circuit 13 inputted through the switch SW3 into the two signals having a phase difference of 90° therebetween, and outputs one of the two signals to the multiplier 26g and the other thereof to the multiplier 26h.

The multiplier 26g multiplies one of the signals from the phase difference generation section 26f and the signal from the DAC 26d, and outputs to the adder 26i. Further, the multiplier 26h also multiplies the other signal from the phase difference generation section 26f and the signal from the DAC 26e, and outputs to the adder 26i. That is, the respective multipliers 26g, 26h perform the amplitude modulation in correspondence with the signal from the noise generation section 21, on the respective signals divided from the phase difference generation section 26f. The adder 26i then adds the outputs from the multipliers 26g, 26h and outputs to the amplitude regulation section 14 through the switch SW4.

As described above, the phase noise characteristic regulation section 22 obtains a phase modulation amount on the basis of the loop band and modulation band so as to obtain the signal of the set values from the noise setting section 20, and performs the phase modulation with the carrier signal, so that the quantitative phase noises can be added to the carrier signal. Thus, desired noises can be added to the carrier signal, and a frequency signal in which the spectral shape of the carrier signal is made to be a desired shape can be output. Therefore, the noise resistance properties of objects to be tested can be measured in good accuracy.

### [Second Embodiment]

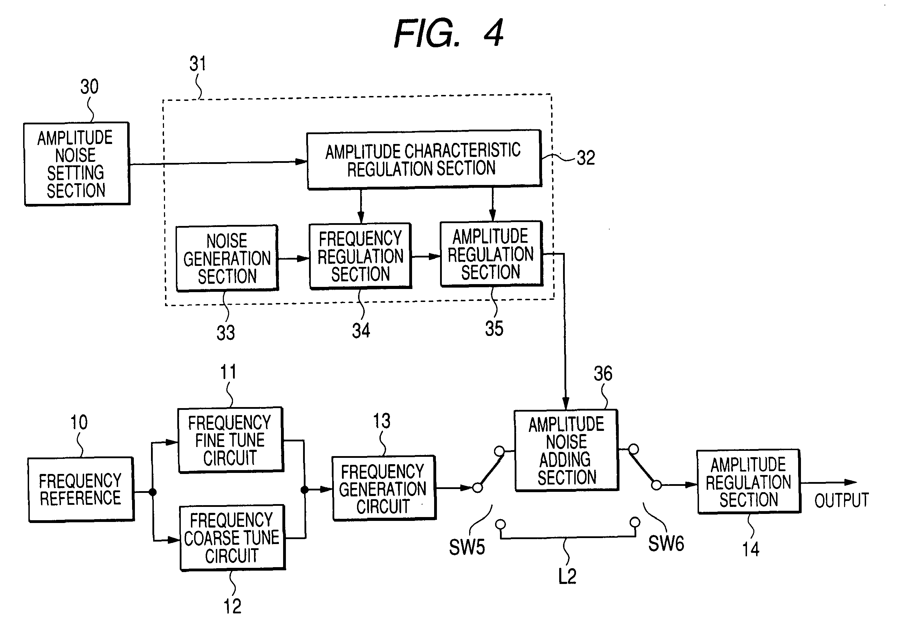

Fig. 4 is a constitutional diagram showing a second embodiment of the invention. Here, the same reference numerals are appended to the same elements as indicated in Fig. 1, and an explanation thereof is omitted.

Fig. 4 shows a case where desired amplitude noises are added to a carrier signal output from the frequency synthesizer. Specifically, the amplitude modulation is performed, and the noises are added to the carrier signal. In Fig. 4, an amplitude noise setting section 30 is provided in place of the phase noise setting section 20. An amplitude noise generation section 31 is provided in place of the phase noise generation section 21. An amplitude noise adding section 36 is provided in place of the phase noise adding section 26. Switches SW5, SW6 and a transmission path L2 are provided in place of the switches SW3, SW4 and transmission path L1.

The amplitude noise setting section 30 sets set values of the amplitude noises to be contained in the signal output from the amplitude regulation section 14. The amplitude noise generation section 31 has an amplitude noise characteristic regulation section 32, a noise generation section 33, a frequency regulation section 34, and an amplitude regulation section 35, and receives the set values from the amplitude noise setting section 30.

The amplitude noise characteristic regulation section 32 receives the set values from the amplitude noise setting section 30. The noise generation section 33 outputs white noises. The frequency regulation section 34 filters the white noises from the noise generation section 33 in accordance with an instruction from the amplitude noise characteristic regulation section 32. The amplitude regulation section 35 regulates an amplitude characteristic for each of the frequency components filtered by the frequency regulation section 34 in accordance with the instruction from the amplitude noise characteristic regulation section 32.

The amplitude noise adding section 36 then performs the amplitude modulation on the signal from the frequency generation circuit 13 on the basis of a signal from the amplitude noise regulation section 35. Incidentally, the amplitude noise generation section 31 corresponds to a noise generation section, and the amplitude noise adding section 36 corresponds to a noise adding section.

The switches SW5, SW6 connect the amplitude noise adding section 36 to the frequency generation circuit 13 and amplitude regulation section 14, respectively, when the amplitude noises are added, and connect the transmission path L2 to the frequency generation circuit 13 and amplitude regulation section 14, respectively, when the amplitude noises are not added.

An operation of the device as described above will be explained.

The set values (for example, -50 [dBc/Hz] at Δf1 (an offset frequency from the carrier frequency), -80 [dBc/Hz] at Δf2, and -100 [dBc/Hz] at Δf3) of the amplitude noises are set in the amplitude noise setting section 30. The set values which have been set are then output to the amplitude noise characteristic regulation section 32.

Further, the amplitude noise characteristic regulation section 32 obtains an amplitude modulation amount to be the set values from the amplitude noise setting section 30, namely, frequencies for the amplitude modulation and amplitudes of the respective frequencies, on the basis of an output frequency of the frequency reference 10, an output frequency of the frequency fine tune circuit 11, a loop bandwidth of the frequency generation circuit 13, and a modulation band of the amplitude noise adding section 36. The phase noise characteristic regulation section 32 outputs an instruction to the frequency regulation section 34 to filter the obtained frequencies, and outputs an instruction to the amplitude regulation section 35 to obtain amplitudes to be the same as the obtained amplitudes. Incidentally, the output frequency of the frequency reference 10, the output frequency of the frequency fine tune circuit 11, and the loop bandwidth of the frequency generation circuit 13, and the modulation band of amplitude noise adding section 36, are determined in advance at a time of manufacturing the device, its calibration, etc. These may be maintained in the amplitude noise characteristic regulation section 32, in advance.

The frequency regulation section 34 then outputs, to the amplitude regulation section 35, only desired frequency noises among the white noises from the noise generation section 33 in accordance with the instruction from the amplitude noise characteristic regulation section 32. Further, the amplitude regulation section 35 regulates the amplitudes of respective frequency components from the frequency regulation section 34 in accordance with the instruction from the amplitude noise characteristic regulation section 32 and outputs to the amplitude noise adding section 36.

The amplitude noise adding section 36 then performs the phase modulation with the carrier signal output from the frequency generation circuit 13 in accordance with the signal from the amplitude regulation section 35, adds amplitude noises to the carrier signal, and outputs to the amplitude regulation section 14.

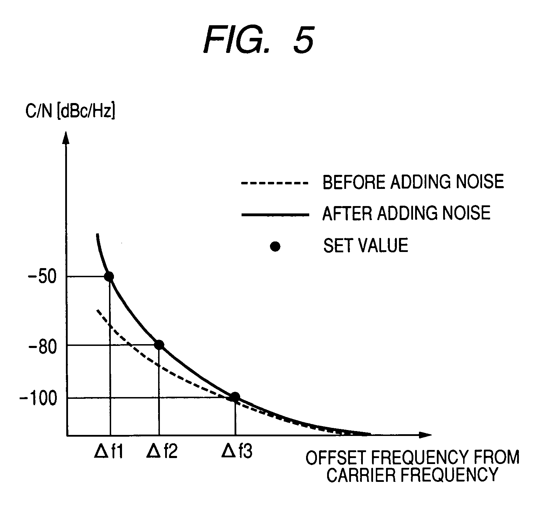

Here, Fig. 5 is a diagram showing one example of adding the amplitude noises to the carrier signal, in which the solid line is a spectrum after adding the amplitude noises to the carrier signal. The dotted line is a spectrum before adding the amplitude noises. The abscissa axis is frequency, and I the vertical axis is C/N (Carrier to Noise) ratio (magnitude of the amplitude noise).

Incidentally, when the amplitude noises are added to the signal from the frequency generation circuit 13, the switches SW5, SW6 switch the connection to the side of amplitude noise adding section 36. On the other hand, when the amplitude noises are not added to the signal from the frequency generation circuit 13, the switch SW5, SW6 switch the connection to the side of transmission path L2.

Other operation is the same as that of the device shown in Fig. 1, therefore, an explanation thereof is omitted.

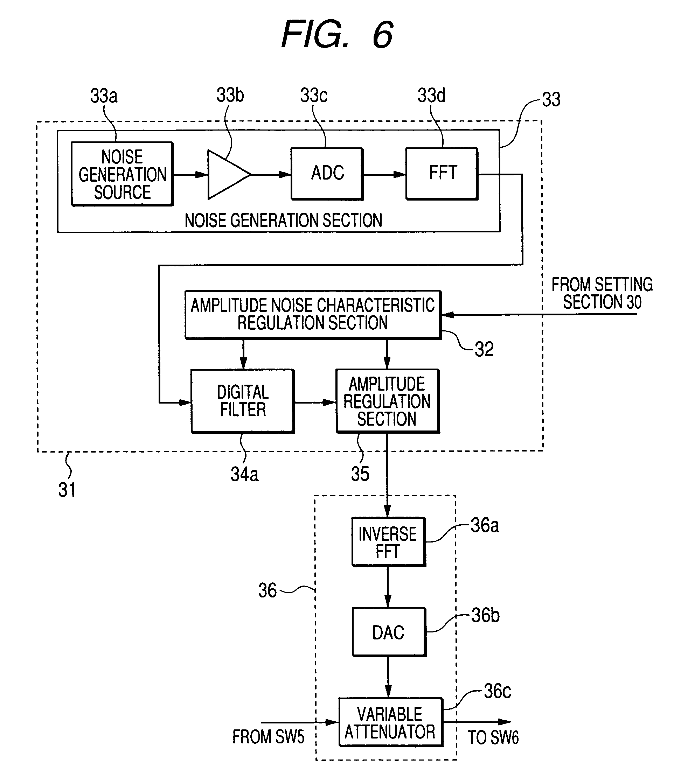

Subsequently, Fig. 6 is a diagram showing a detailed constitution of the amplitude noise generation section 31 and the amplitude noise adding section 36 shown in Fig. 4. In Fig. 6, the noise generation section 33 has a noise generation source 33a, an amplifier 33b, an ADC 33c, and an FFT operation section 33d.

The amplifier 33b receives a noise signal from the noise generation source 33a. The ADC 33c receives a noise signal amplified by the amplifier 33b. The FFT operation section 33d receives a digital signal converted by the ADC 33c.

A digital filter 34a is one example of the frequency regulation section 34, and receives the instruction from the amplitude noise characteristic regulation section 32 and a result of the Fourier transform performed by the FFT operation section 33d.

Further, the amplitude noise adding section 36 has an inverse FFT operation section 36a, a DAC 36b, and a variable attenuator 36c.

The inverse FFT operation section 36a receives the signal from the amplitude regulation section 35. The DAC 36b receives a result of the inverse the Fourier transform performed in the inverse FFT operation section 36a. The variable attenuator 36c performs the amplitude modulation on the signal inputted from the frequency generation circuit 13 through the switch SW5 on the basis of a signal from the DAC 36b, and outputs to the switch SW6.

An operation of the device as described above will be explained

The amplifier 33b amplifies the white noises output from the noise generation source 33a by a predetermined gain and outputs to the ADC 33c. The ADC 33c then converts the white noises of an analog signal into a digital signal and outputs the digital signal to the FFT operation section 33d. Further, the FFT operation section 33d performs the Fourier transform on the digital signal and outputs the digital signal to the digital filter 34a.

The digital filter 34a then filters the Fourier transformed data (of course, spectrums are present uniformly at a predetermined band) in accordance with the instruction from the amplitude noise characteristic regulation section 32, and transmits only spectrums present in desired frequencies. Further, the amplitude regulation section 35 regulates an electric power of the spectrum for each of the frequencies after filtered by the digital filter 34a, and outputs to the inverse FFT operation section 36a.

The inverse FFT operation section 36a performs the inverse the Fourier transform on the data from the amplitude regulation section 35, and outputs a transformed result to the DAC 36b. Further, the DAC 36b converts the digital signal to an analog signal and outputs the analog signal to the variable attenuator 36c. The variable attenuator 36c performs the amplitude modulation on the carrier signal from the frequency generation circuit 13 on the basis of the signal of DAC 36b, and outputs to the amplitude regulation section 14 through the switch SW6.

As described above, the amplitude noise characteristic regulation section 32 obtains an amplitude modulation amount on the basis of the loop band and modulation band so as to obtain the signal of the set values from the amplitude noise setting section 30, and performs the amplitude modulation with the carrier signal, so that the quantitative amplitude noises can be added. Thus, desired noises can be added to the carrier signal, and the frequency signal in which the spectral shape of the carrier signal is made to be a desired shape can be output. Therefore, the noise resistance properties of objects to be tested can be measured in good accuracy.

### [Third Embodiment]

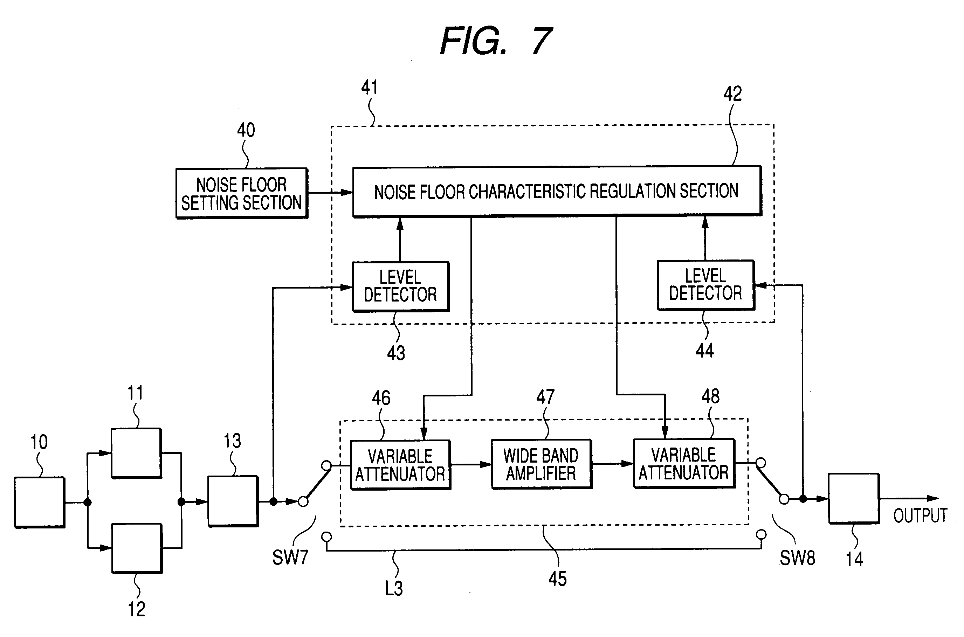

Fig. 7 is a constitutional diagram showing a third embodiment of the invention. Here, the same reference numerals are appended to the same elements as indicated in Fig. 1, and an explanation thereof is omitted. Normally, the carrier signal output from the frequency synthesizer has a low noise. The noise relative to an electric power of the center frequency of carrier signal is suppressed to a low level, which is mostly negligible to some extent, at a position sufficiently away from the carrier frequency, namely, at a position regarded as a noise floor. The C/N ratio is therefore remarkably high. Fig. 7 shows that the C/N ratio in the noise floor is made to be a desired value.

In Fig. 7, a noise floor setting section 40 is provided in place of the phase noise setting section 20. A noise floor generation section 41 is provided in place of the phase noise generation section 21. A noise floor adding section 45 is provided in place of the phase noise adding section. Switches SW7, SW8 and a transmission path L3 are provided in place of the switches SW3, SW4 and transmission path L1.

The noise floor setting section 40 sets set values of the noise floor to be contained in the signal output from the amplitude regulation section 14. The noise floor generation section 41 has a noise floor characteristic regulation section 42 and level detectors 43, 44, and receives set values from the noise floor setting section 40, a signal from frequency generation circuit 13, and a signal output to the amplitude regulation section 14.

The noise floor characteristic regulation section 42 receives the set values from the noise floor setting section 40 and detected results from the level detectors 43, 44. The level detector 43 receives the signal from the frequency generation circuit 13. The level detector 44 receives the signal output to the amplitude regulation section 14.

The noise floor adding section 45 has variable attenuators 46, 48 and a wide band amplifier 47. The noise floor adding section 45 regulates the noise floor of the signal inputted to a noise generation section, and the noise floor adding section 45 corresponds to a noise addition section.

The switches SW7, SW8 connect the noise floor adding section 45 to both the frequency generation circuit 13 and amplitude regulation section 14 when the noise floor is added, and connect the transmission path L3 to both the frequency generation circuit 13 and amplitude regulation section 14 when the noise floor is not added.

An operation of the device as described above will be explained.

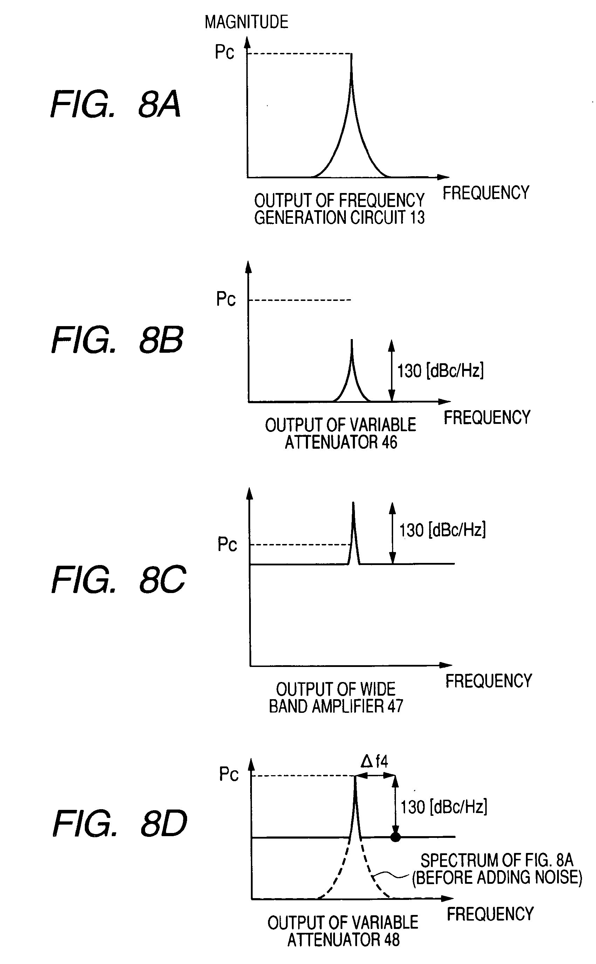

Figs. 8A-8D are diagrams each representing a spectrum of the signal in the device shown in Fig. 7 in which the abscissa axis indicates frequency and the vertical axis indicates spectrum magnitude (electric power). Fig. 8A shows the output of frequency generation circuit 13. Fig. 8B shows the output of variable attenuator 46. Fig. 8C shows the output of the wide band amplifier 47. Fig. 8D shows the output of variable attenuator 48. Incidentally, an electric power level of the carrier signal from the frequency generation circuit 13 is set to Pc, and a black circle shown in Fig. 8D indicates a set value.

Set values (for example, -130 [dBc/Hz] at Δf4 which is an offset frequency from carrier frequency (sufficiently away from the carrier signal, and a position where the influence on spectrum of the carrier signal is negligible)) of the noise floor is set to the noise floor setting section 40. The set values are output to the noise floor characteristic regulation section 42.

On the contrary, the level detector 43 obtains a ratio of an electric power level of the carrier frequency and a level of the noise floor from the signal (referring to Fig. 8A) of the frequency generation circuit 13, and outputs to the noise floor characteristic regulation section 42. The noise floor characteristic regulation section 42 then regulates the attenuation ratio of variable attenuator 46 so as to obtain the set values. Whereby, the variable attenuator 46 attenuates the signal from the frequency generation circuit 13 in accordance with the instruction of the noise floor characteristic regulation section 42.

Further, the wide band amplifier 47 amplifies both the carrier signal and noise floor, and outputs to the variable attenuator 48 (referring to Fig. 8C). The variable attenuator 48 then outputs the signal from the wide band amplifier 47 to the level detector 44 through the switch SW8, with a predetermined amount of attenuation or without attenuation.

The level detector 44 then obtains an electric power level at the carrier frequency, and the ratio of the electric power level and the level of noise floor, in accordance with the output from the variable attenuator 48 entered through the switch SW8, and outputs to the noise floor characteristic regulation section 42.

The noise floor characteristic regulation section 42 then regulates the attenuation ratio of variable attenuator 48 so that the electric power Pc of the signal output from the frequency generation circuit 13 becomes the same level with the electric power of the signal output from the variable attenuator 48. Further, the variable attenuator 48 attenuates the signal from the wide band amplifier 47 in accordance with the instruction of the noise floor characteristic regulation section 42, and outputs to the level detector 44 and amplitude regulation section 14 through the switch SW8 (referring to Fig. 8D) .

Other operation is the same as the device shown in Fig. 1, therefore, an explanation thereof is omitted.

As described above, the noise floor characteristic regulation section 42 makes the variable attenuators 46, 48 attenuate and amplify the carrier signal on the basis of the detected results of level detectors 43, 44 so as to obtain the signal of the set value from the noise setting section 40. Therefore, the noise floor can be set to a desired level for the electric power level of carrier signal. Whereby, a desired noise can be added to the carrier signal, and the frequency signal in which a spectral shape of the carrier signal is made to be a desired shape can be output. Therefore, the noise resistance properties of objects to be tested can be measured in good accuracy.

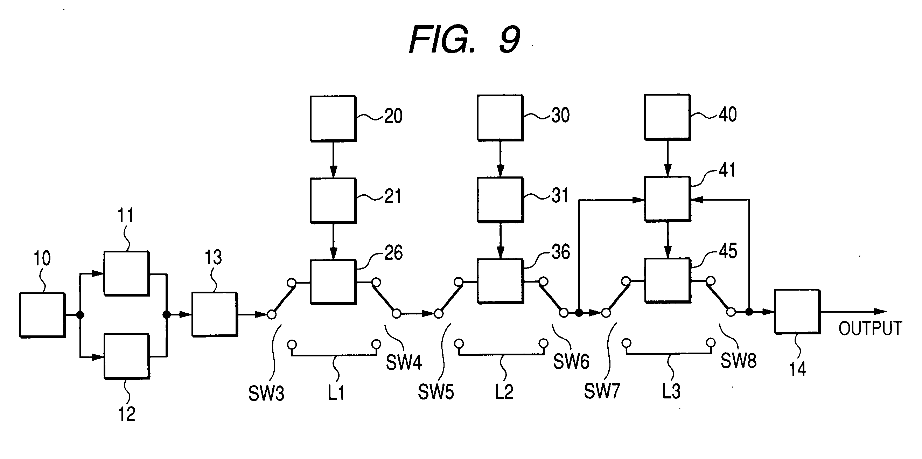

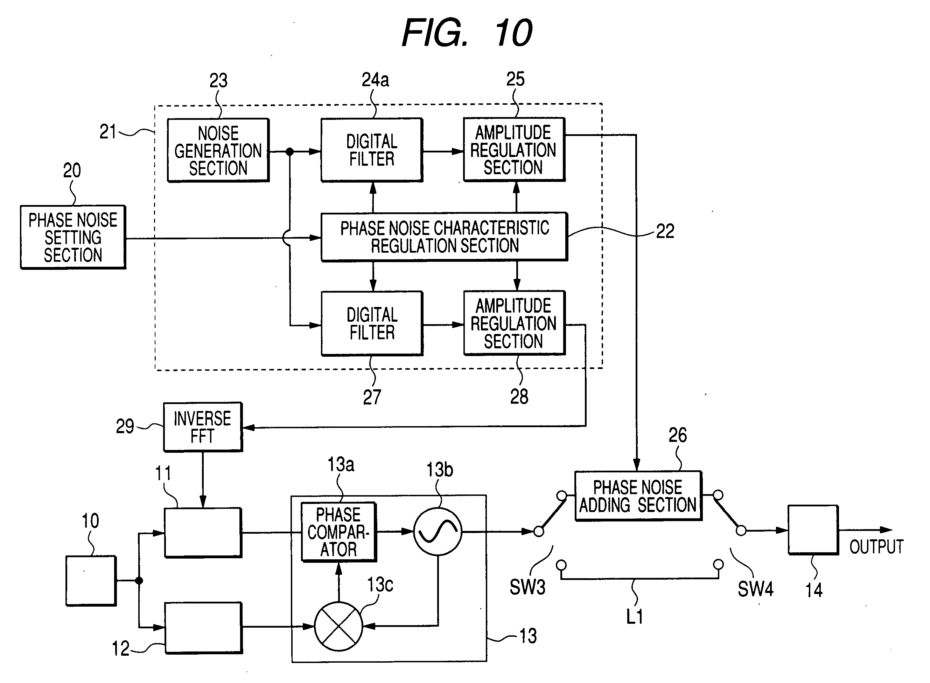

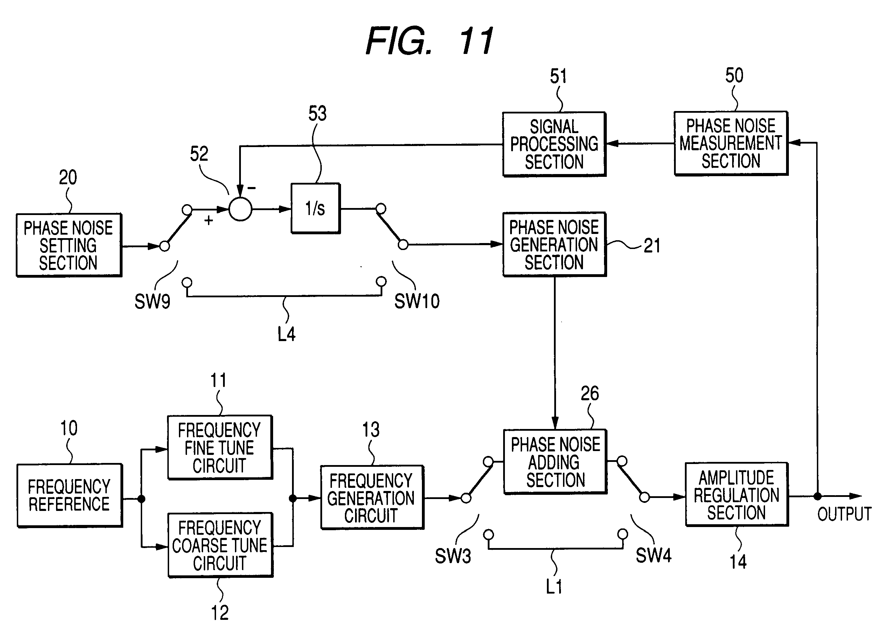

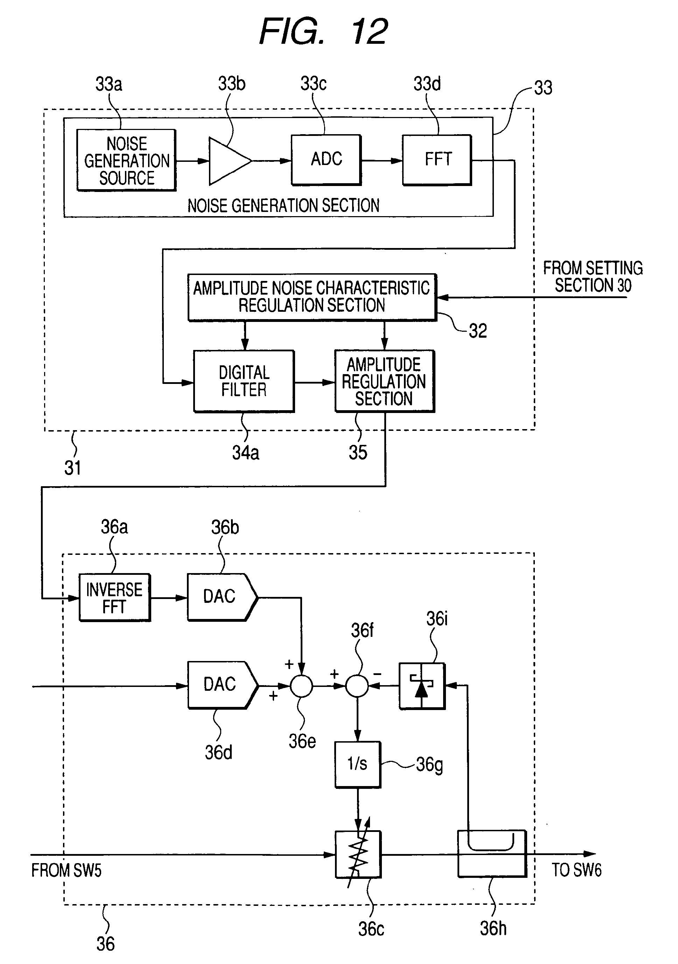

Incidentally, the invention is not limited by the aforementioned embodiments, but the following alternatives may also be applicable.
(1) In the device shown in Fig. 1, Fig. 4 and Fig. 7, the constitution has been shown that each of the phase noise, amplitude noise and noise floor is added separately, but each required noise may also be added together. For example, the constitution may also be applicable as shown in Fig. 9. Here, the same reference numerals are appended to the same elements as indicated in Fig. 1, Fig. 4 and Fig. 7, and an explanation thereof is omitted.
   In Fig. 9, sections 20, 21, 26, SW3, SW4, and L1, for adding the phase noise are connected in series. Sections 30, 31, 36, SW5, SW6, and L2, for adding the amplitude noise are connected in series. Sections 40, 41, 45, SW7, SW8, and L3, for adding the noise floor are connected in series. Of course, the switches SW3 to SW8 select the transmission paths L1 to L3 when it is not required to add the noises. Further, any order of arranging the sections for adding each of the noises may be employed, and sections for two kinds of noises may also be provided.
(2) The invention in Fig. 1, Fig. 4 and Fig. 7 has been explained as the constitution applicable to the device shown in Fig. 13. The constitution may also be applicable to the frequency synthesizer provided with the modulation circuits 15 to 19 shown in Fig. 14. In this case, the sections 15, 18 for performing the amplitude modulation and the sections 16, 19 for performing the IQ modulation may preferably be provided on the rear stage of the noise adding sections 26, 36, 45 for adding the noise to the carrier signal.
(3) In the devices shown in Fig. 1, Fig. 4 and Fig. 7, any number of the set values set by the setting sections 20, 30, 40 may be used, and any values may also be used for the set values.
(4) In the devices shown in Fig. 1 and Fig. 4, the constitution indicates that the digital filters 24a, 34a are used as one example of the frequency regulation section 24, 34, but analog filters may also be used. In this case, it is not required to digitalize the white noise from the noise generation section 33, therefore, it is not required to provide the ADCs 23c, 33c, FFT operation sections 23d, 33d, inverse FFT operation sections 26b, 26c, 36a, and DAC 26d, 26e, 36b.
(5) In the device shown in Fig. 1, the constitution indicates that the phase noise adding section 26 performs the phase modulation on the carrier signal on the basis of the signal from the phase noise generation section 21. For example, when the frequency generation circuit 13 is constituted by a phase synchronizing loop using a PLL circuit, the constitution shown in Fig. 10 may also be used in the case of adding the phase noise having a lower band than the loop band of the phase synchronizing loop. Here, the same reference numerals are appended to the same elements as indicated in Fig. 1 and Fig. 3, and explanations thereof are omitted. In Fig. 10, the frequency generation circuit 13 constitutes a closed loop with a phase comparator 13a, a VCO 13b and a mixer 13c. The phase comparator 13a then compares phases of signals from the frequency fine tune circuit 11 and mixer 13c, and controls the output frequency of VCO 13b in accordance with a compared result. The VCO 13b outputs the output frequency to the switch SW3 and mixer 13c. The mixer 13c then mixes the outputs from the VCO 13b and the frequency coarse tune circuit 12 to output to the phase comparator 13a.
   Further, a digital filter (a second frequency characteristic regulation section) 27 and a second amplitude regulation section 28 are provided in the phase noise generation section 21.
   An inverse FFT operation section 29 is provided as a second phase noise adding section (corresponding to the noise adding section). A signal from the amplitude regulation section 28 as a phase modulation signal source is performed by the inverse Fourier transform, and the transformed signal is output to the frequency fine tune circuit 11.
   An operation of the device as described above will be explained.
   This operation is substantially the same as that shown in Fig. 1 and Fig. 3. A different operation is that the phase noise characteristic regulation section 22 obtains a phase modulation amount to obtain the signal of the set values from the phase noise setting section 20, namely frequencies for the phase modulation and amplitudes of the respective frequencies, on the basis of the output frequency of the frequency reference 10, the output frequency of the frequency fine tune circuit 11, the loop bandwidth of the frequency generation circuit 13, and the modulation band of phase noise adding section 26. The phase noise characteristic regulation section 22 then outputs the instruction to the digital filters 24a, 27 to filter the obtained frequencies, and outputs the instruction to the amplitude regulation section 25, 28 to have the amplitude which is the same as the obtained amplitudes.
   At this time, the instruction is output to the digital filter 24a and amplitude regulation section 25 with regard to the phase modulation amount of the components of phase noises which are in a higher band than the loop band of frequency generation circuit 13. The instruction is output to the digital filter 27 and amplitude regulation section 28 with regard to the phase modulation amount of the components of phase noises which are in a lower band.
   The respective digital filters 24a, 27 output only a desired frequency noise among the white noises from the noise generation section 23 to the amplitude regulation sections 25, 28 in accordance with the instruction from the phase noise characteristic regulation section 22. Further, the respective amplitude regulation sections 25, 28 regulate the amplitudes of the respective frequency components from the digital filters 24a, 27, and output to the phase noise adding section 26 and inverse FFT means 29 in accordance with the instruction from the phase noise characteristic regulation section 22.
   Further, the inverse FFT operation section 29 performs the inverse Fourier transform on the signal from the amplitude regulation section 28, and outputs the transformed signal to the frequency fine tune circuit 11. The frequency fine tune circuit 11 then performs the phase modulation on the basis of the signal from the inverse FFT operation section 29, and outputs to the phase comparator 13a in the frequency generation circuit 13. Other operation is the same as that of the device shown in Fig. 1 and Fig. 3, therefore, an explanation thereof is omitted.
   In fact, the signal entered into the phase noise adding section 26 is a signal for regulating the phase noise having only band components higher than those of the amplitude regulation section 28. The phase noise adding section 26 performs the phase modulation, using the signal from the amplitude regulation section 25 as a phase modulation signal source, on the carrier signal from the frequency generation circuit 13, and the phase noise is then added to the carrier signal.
   Of course, in Fig. 10, in the case where the band of phase noise on the basis of the set values entered into the phase noise setting section 20 is only set to a lower band than the loop the carrier signal from the frequency generation circuit 13, and the phase noise is then added to the carrier signal.
   Of course, in Fig. 10, in the case where the band of phase noise on the basis of the set values entered into the phase noise setting section 20 is only set to a lower band than the loop band of frequency generation circuit 13, the frequency regulation section 24, amplitude regulation section 25, phase noise adding section 26, switches SW3, SW4, and transmission path L1, may not be provided.
(6) In the device shown in Fig. 7, the variable attenuator 48 shows the constitution for attenuating the signal amplified by the wide band amplifier 47, however, the amplification factor of the wide band amplifier 47 may be made variable without providing the variable attenuator 48. The wide band amplifier 47 regulates the signal from the variable attenuator 46 and outputs to the switch SW8 in accordance with the instruction from the noise floor characteristic regulation section 42 so that the electric power level of the amplified carrier signal becomes Pc.
(7) In the case of adding the phase noise in the devices shown in Fig. 1, Fig. 9 and Fig. 10, the constitution indicates that the phase noise is controlled by the open loop. However, the noise amount of phase noise may also be regulated by feeding-back the output of the amplitude regulation section 14. An explanation will be described with use of Fig. 11. The same
   In Fig. 11, a phase noise measurement section 50, a signal processing section 51, a subtractor 52 and an integrator 53 are newly provided. The phase noise measurement section 50 measures phase noises of the signal output from the amplitude regulation section 14. The signal processing section 51 receives a measured result from the phase noise measurement section 50. The subtractor 52 receives signals from the phase noise setting section 20 and the signal processing section 51. The integrator 53 receives a subtracted result from the subtractor 52, integrates the subtracted result with respect to a predetermined time, and outputs an integrated result to the phase noise generation section 21.
   Further, the transmission path L4 is provided between the phase noise setting section 20 and phase noise generation section 21 in parallel with the subtractor 52 and integrator 53. The SW9 connects the output side of phase noise setting section 20 to the input side of either the subtractor 52 or the transmission path L4. The switch SW10 connects the input side of the phase noise generation section 21 to the output side of either the integrator 53 or the transmission path L4.
   An operation of the device as described above will be explained.
   Similarly to the device shown in Fig. 1, an explanation is made from a case where the phase noise is controlled by the open loop. The switches SW9, SW10 switch the connection to the side of transmission path L4. Similarly to the device shown in Fig. 1, the phase noise setting section 20 then outputs the set values to the phase noise generation section 21. Other operation is the same as that of the device shown in Fig. 1, therefore, an explanation thereof is omitted.
   Next, a case where the output of amplitude regulation section 14 is fed back to regulate the noise amount of phase noise will be explained.
   The SW9, SW10 switch the connection to the sides of subtractor 52 and integrator 53. The phase noise setting section 20 then outputs set values to the subtractor 52. Further, the subtractor 52 subtracts the values from the signal processing section 51 from the values of phase noise setting section 20, and outputs to the integrator 53.
   The integrator 53 outputs the integrated result with respect to the predetermined time to the phase noise generation section 21 through the switch SW10. Similarly to the device shown in Fig. 1, the phase noise generation section 21 generates a predetermined phase noise. Further, the phase noise adding section 26 performs the phase modulation with the carrier signal from the frequency generation circuit 13 in accordance with the signal from the phase noise generation section 21 to add the phase noise to the carrier signal, and outputs to the amplitude regulation section 14. The amplitude regulation section 14 makes the carrier signal to be a desired output level (amplitude) and then outputs the signal.
   Further, the phase noise measurement section 50 measures a phase noise of the output signal from the amplitude regulation section 14 (see JP-A-2005-308509, etc., for example, as the measurement of the phase noise) and outputs a measured result to the signal processing section 51. The signal processing section 51 then performs a predetermined operation on the measured result and outputs an operation result to the subtractor 52. Thus, the subtractor 52 again obtains a difference between the set values from the phase noise setting section 20 and the measured result from the signal processing section 51. The subtracted result which has been obtained again is output to the integrator 53. As described above, with the feed-back operated repeatedly, the phase noise is regulated so that the difference between the phase noise added to the signal output from the amplitude regulation section 14 and the set value of phase noise setting section 20 becomes "0". Other operation is the same as that of the device shown in Fig. 1, therefore, an explanation thereof is omitted.
   As describe above, the phase noise measurement section 50 measures the phase noise of the output signal from the amplitude regulation section 14. The subtractor 52 obtains the difference between the set values of phase noise and the set values from the phase noise setting section 20, and outputs a signal for reducing errors with respect to the set values to measures the phase noise of the output signal from the amplitude regulation section 14. The subtractor 52 obtains the difference between the measured result of phase noise and the set values from the phase noise setting section 20, and outputs a signal for reducing errors with respect to the set values to the phase noise generation section 21. Thus, the signal is converged so that the difference from the phase noise becomes "0". Therefore, the phase noise set to the phase noise setting section 20 can be added to the carrier signal in good accuracy.
(8) In the case of adding the amplitude noise to the carrier signal in the devices shown in Fig. 4, Fig. 6 and Fig. 9, the configuration is shown in which the variable attenuator 36c in the amplitude noise adding section 36 is open-loop controlled in accordance with the signals from the amplitude regulation section 35 in the amplitude noise generation section 31. However, a closed loop control may be configured in which the amplitude noise may also be regulated by feeding back the signal added with the noise in the amplitude noise adding section 36. An explanation to the closed loop control will be stated with reference to Fig. 12. The same reference numerals are appended to the same elements as indicated in Fig. 6, and an explanation thereof is omitted.

In Fig. 12, a DAC 36d, an adder 36e, a subtractor 36f, an integrator 36g, a electric power dividing section 36h and a subtractor 36f receives an added result (voltage value) of the adder 36e and a detected value (voltage value) of the electric power detection section 36i. The integrator 36g receives a subtracted result of the subtractor 36f, integrates it with respect to a predetermined time, and outputs an integrated result to the variable attenuator 36c. The electric power dividing section 36h divides a signal to which the amplitude noise is added by the variable attenuator 36c into signals by a predetermined ratio, and outputs one of the divided signals to the SW6 and the other thereof to the electric power detection section 36i. The electric power dividing section 36h is a directional coupler, a electric power distributor, etc., for example. The electric power detection section 36i is an envelope curve wave detector, a logarithmic amplifier, etc., for example.

By the above- described constitution (DAC 36d for outputting the reference voltage, and the closed loop (subtractor 36f, integrator 36g, variable attenuator 36c, electric power dividing section 36h, and electric power detection section 36i)), a function of ALC (Auto Level Control) is given to the noise adding section 36.

An operation of the device as described above will be explained. First, an operation of the ALC function will be explained.

The DAC 36d outputs the reference voltage to the subtractor 36f through the adder 36e. On the contrary, the electric power 36i)), a function of ALC (Auto Level Control) is given to the amplitude noise adding section 36.

An operation of the device as described above will be explained. First, an operation of the ALC function will be explained.

The DAC 36d outputs the reference voltage to the subtractor 36f through the adder 36e. On the contrary, the electric power dividing section 36h fetches a part of the electric power of the signal output by the variable attenuator 36c and outputs to the electric power detection section 36i. The electric power detection section 36i then detects the magnitude of electric power, generates the signal of voltage value indicating the magnitude of detected electric power, and outputs to the subtractor 36f.

Further, the subtractor 36f obtains a difference between the reference voltage from the DAC 36d and the voltage from the electric power detection section 36i. The obtained result from the operation, namely the difference between the reference voltage and the detected voltage is output to the integrator 36g. The integrator 36g then outputs a signal corresponding to the difference to the variable attenuator 36c. In response to the signal, the variable attenuator 36c attenuates the carrier signal from the frequency generation circuit 13 and outputs to the electric power dividing section 36h.

An attenuated voltage value is again obtained by the electric power dividing section 36h and electric power detection section amplitude noise adding section 36 becomes substantially zero. Consequently, the output level of amplitude noise adding section is made stabilized, and becomes the set output level.

Next, an explanation will be described for a case of adding the amplitude noise. The adder 36e adds the voltage (the signal used for the amplitude noise generated on the basis of the amplitude noise generation section 31) from the DAC 36b to the output from the DAC 36d to be the reference voltage of an ALC circuit, and outputs to the subtractor 36f. The closed loop circuit from the rear stage of ALC where the addition is carried out follows the signal of reference voltage added with the noise in the loop response band. In fact, the signal added with the amplitude noise is output from the amplitude noise adding section 36 while ALC is carried out. The amplitude regulation section 14 of the rear stage then amplifies the output so that a desired gain is obtained.

Incidentally, the variable attenuator 36c in the amplitude noise adding section 36 performs the amplitude modulation on the carrier signal from the frequency generation circuit 13 and outputs to the amplitude regulation section 14. The amplifier 14a and the variable attenuator 14b in the amplitude regulation section 14 make the amplitude-modulated signal to be the desired output level (amplitude) and output the signal. However, the attenuation executed in the variable attenuator 14b may also be carried out by the variable attenuator 36c in the amplitude outputs to the amplitude regulation section 14. The amplifier 14a and the variable attenuator 14b in the amplitude regulation section 14 make the amplitude-modulated signal to be the desired output level (amplitude) and output the signal. However, the attenuation executed in the variable attenuator 14b may also be carried out by the variable attenuator 36c in the amplitude noise adding section 36 without providing the variable attenuator 14b.

As described above, the output of DAC 36d is set to the reference voltage. The adder 36e adds the output of DAC 36b to the reference voltage and outputs to the subtractor 36f. The subtractor 36f then obtains the difference between the output of variable attenuator 36c and the reference voltage, and outputs the signal for decreasing an error from the reference signal to the variable attenuator 36c. Thus, the output from the variable attenuator 36c is converged so that the difference between the output of variable attenuator 36c and the reference voltage becomes "0". Therefore, the amplitude from the amplitude noise adding section 36 becomes stable.

The present invention has various advantages.

According to the frequency synthesizer of the invention, the noise generation section generates the noise to be the set value, and the noise adding section adds the noise from the noise generation section to the signal from the signal generation section, so that quantitative noises can be added to the signal. noise generation section generates the noise that makes the spectrum of the signal from the signal generation section be a desired shape, on the basis of a loop band of the signal generation section, and the noise adding section adds the obtained noise to the signal from the signal generation section, so that quantitative noises can be added to the signal. Thus, the desired noises can be added to the signal from the signal generation section, and the spectral shapes of the signal from the signal generation section can be made to be a desired shape. Therefore, the noise resistance properties of objects to be tested can be measured in good accuracy.

According to the frequency synthesizer of the invention, the level detector obtains a ratio of an electric power level and a noise level of the center frequency of the signal from the signal generation section, and the noise floor characteristic regulation section regulates an attenuation amount of the variable attenuator on the basis of the ratio obtained by the level detector, so that the quantitative noises can be added to the signal. Whereby, the desired noises can be added to the signal from the signal generation section, the spectral shapes of the signal from the signal generation section can be made to be a desired shape. Therefore, the noise resistance properties of objects to be tested can be measured in good accuracy.

It will be apparent to those skilled in the art that various modifications and variations can be made to the described preferred embodiments of the present invention without departing from the spirit or scope of the invention. Thus, it is intended that the present invention cover all modifications and variations of this invention consistent with the scope of the appended claims and their equivalents.
Fig. 1
   10: frequency reference
   11: frequency fine tune circuit
   12: frequency coarse tune circuit
   13: frequency generation circuit
   14: amplitude regulation section
   20: phase noise setting section
   22: phase noise characteristic regulation section
   23: noise generation section
   24: frequency regulation section
   25: amplitude regulation section
   26: phase noise adding section
   #1: output
Fig.2
   #1: before adding noise
   #2: after adding noise
   #3: set value
   #4: offset frequency from carrier frequency
Fig.3
   22: phase noise characteristic regulation section
   #1: from setting section 20
   23: noise generation section
   23a: noise generation source
   24a: digital filter
   25: amplitude regulation section
   26a: phase difference generation section
   26b: inverse FFT
   26c: inverse FFT
   26f: phase difference generation section
   #2: from SW3
   26g: multiplier
   26h: multiplier
   26i: adder
   #3: to SW4
Fig.4
   10: frequency reference
   11: frequency fine tune circuit
   12: frequency coarse tune circuit
   13: frequency generation circuit
   14: amplitude regulation section
   #1: output
   30: amplitude noise setting section
   32: amplitude characteristic regulation section
   33: noise generation section
   34: frequency regulation section
   35: amplitude regulation section
   36: amplitude noise adding section
Fig.5
   #1: before adding noise
   #2: after adding noise
   #3: set value
   #4: offset frequency from carrier frequency
Fig.6
   32: amplitude noise characteristic regulation section
   #1: from setting section 30
   33: noise generation section
   33a: noise generation source
   34a: digital filter
   35: amplitude regulation section
   36a: inverse FFT
   36c: variable attenuator
   #2: from SW5
   #3: to SW6
Fig.7
   40: noise floor setting section
   42: noise floor characteristic regulation section
   43: level detector
   44: level detector
   46: variable attenuator
   47: wide band amplifier
   48: variable attenuator
   #1: output
Fig. 8A
   #3: magnitude
   #2: frequency
   #1: output of frequency generation circuit 13
Fig. 8B
   #1: output of variable attenuator 46
   #2: frequency
Fig.8C
   #1: output of wide band amplifier 47
   #2: frequency
Fig.8D
   #3: spectrum of Fig.8A (before adding noise)
   #1: output of variable attenuator 48
   #2: frequency
Fig.9
   #1: output
Fig. 10
   13a: phase comparator
   #1: output
   20: phase noise setting section
   22: phase noise characteristic regulation section
   23: noise generation section
   24a: digital filter
   25: amplitude regulation section
   26: phase noise adding section
   27: digital filter
   28: amplitude regulation section
   29: inverse FFT
Fig.11
   10: frequency reference
   11: frequency fine tune circuit
   12: frequency coarse tune circuit
   13: frequency generation circuit
   14: amplitude regulation section
   #1 : output
   20: phase noise setting section
   21: phase noise generation section
   26: phase noise adding section
   50: phase noise measurement section
   51: signal processing section
Fig.12
   32: amplitude characteristic regulation section
   #1: from setting section 30
   33: noise generation section
   33a: noise generation source
   34a: digital filter
   35: amplitude regulation section
   36a: inverse FFT
   #2: from SW5
   #3: to SW6
Fig.13
   10: frequency reference
   11: frequency fine tune circuit
   12: frequency coarse tune circuit
   13: frequency generation circuit
   #1 : output
Fig.14
   10: frequency reference
   11: frequency fine tune circuit
   12: frequency coarse tune circuit
   13: frequency generation circuit
   #1 : output
   15: amplitude modulation circuit
   16: IQ modulation circuit
   17: frequency modulation signal generation circuit
   18: amplitude modulation signal generation circuit
   19: IQ modulation signal generation circuit

## Claims

1. A frequency synthesizer, comprising:
a signal generation section for outputting a signal having a desired frequency;
a noise generation section for generating a noise to be a set value; and
a noise adding section for adding the noise from the noise generation section to the signal from the signal generation section.

2. The frequency synthesizer according to claim 1, wherein the noise generation section generates the noise that makes a spectrum of the signal from the signal generation section be a desired shape, on the basis of a loop band of the signal generation section.

3. The frequency synthesizer according to claim 1, wherein the noise generation section generates at least one of a phase noise, an amplitude noise, and a noise floor.

4. The frequency synthesizer according to claim 1, wherein the noise generation section includes:
a white noise generation section for outputting a white noise;
a phase noise characteristic regulation section for obtaining a phase modulation amount on the basis of a loop band of the signal generation section;
a frequency regulation section for regulating a frequency characteristic of the white noise from the white noise generation section in accordance with an instruction from the phase noise characteristic regulation section; and
an amplitude regulation section for regulating an amplitude characteristic of a signal from the frequency regulation section in accordance with an instruction from the phase noise characteristic regulation section.

5. The frequency synthesizer according to claim 4, wherein the noise adding section is a quadrature modulator.

6. The frequency synthesizer according to claim 5, further comprising:
a phase difference generation section for dividing the signal from the signal generation section into signals having a phase difference of 90°;
multipliers for performing an amplitude modulation corresponding to a signal from the noise generation section, on each of the signals divided by the phase difference generation section; and
an adder for adding outputs from the multiplier.

7. The frequency synthesizer according to claim 1, wherein the noise generation section includes:
a white noise generation section for outputting a white noise;
an amplitude noise characteristic regulation section for obtaining an amplitude modulation amount on the basis of a loop band of the signal generation section;
a frequency regulation section for regulating a frequency characteristic of the white noise from the white noise generation section in accordance with an instruction from the amplitude noise characteristic regulation section; and
an amplitude regulation section for regulating an amplitude characteristic of a signal from the frequency regulation section in accordance with an instruction from the amplitude noise characteristic regulation section.

8. The frequency synthesizer according to claim 7, wherein the noise adding section includes a variable attenuator for performing an amplitude modulation corresponding to a signal from the noise generation section, on the signal from the signal generation section.

9. The frequency synthesizer according to claim 1, wherein the noise adding section includes a variable attenuator for attenuating the signal from the signal generation section, and the noise generation section includes:
a level detector for obtaining a ratio of a electric power level and a noise level of a center frequency of the signal from the signal generation section; and
a noise floor characteristic regulation section for regulating an attenuation amount of the variable attenuator on the basis of the ratio obtained by the level detector.

10. The frequency synthesizer according to claim 4, further comprising:
a phase noise measurement section for measuring a phase noise of the signal to which the phase noise is added by the noise adding section; and
a subtractor for outputting a signal that reduces an error between the set value and the phase noise measured by the phase noise measurement section, to the noise generation section.

11. The frequency synthesizer according to claim 8, further comprising:
an electric power detection section for detecting an electric power of the signal to which an amplitude noise is added by the variable attenuator and outputting a voltage value corresponding to a magnitude of the detected electric power;
a reference voltage output section for outputting a reference voltage;
an adder for adding the amplitude noise from the noise generation section, to the reference voltage from the reference voltage output section; and
a subtractor for outputting a signal that reduces an error between the reference voltage from the adder and the voltage value as a detection result by the electric power detection section, to the variable attenuator.
